# EUROPÄISCHE PATENTSCHRIFT

(11) **EP 3 414 785 B1**
(45) Veröffentlichungstag und Bekanntmachung des Hinweises auf die Patenterteilung: **22.09.2021**
(21) Anmeldenummer: 17700231.8
(22) Anmeldetag: 10.01.2017
(51) Int. Cl.: H01L 41/107, H01L 41/257, H05H 1/24

(54) **VERFAHREN ZUR HERSTELLUNG EINES PIEZOELEKTRISCHEN TRANSFORMATORS**
METHOD FOR PRODUCING A PIEZOELECTRIC TRANSFORMER
PROCÉDÉ DE FABRICATION D'UN TRANSFORMATEUR PIÉZOÉLECTRIQUE

(30) Priorität: 12.02.2016 DE 102016102488
(43) Veröffentlichungstag der Anmeldung: 19.12.2018
(73) Patentinhaber: TDK Electronics AG, 81671 München (DE)
(72) Erfinder: DOELLGAST, Bernhard, 8530 Deutschlandsberg (AT); PUFF, Markus, 8010 Graz (AT); KUDELA, Pavol, 8530 Deutschlandsberg (AT); WEILGUNI, Michael, 4232 Hagenberg (AT)
(74) Vertreter: Epping - Hermann - Fischer
(86) Internationale Anmeldenummer: PCT/EP2017/050412
(87) Internationale Veröffentlichungsnummer: WO 2017/137195

(56) Entgegenhaltungen:
- EP-A1- 0 794 580
- WO-A2-2007/006298
- DE-A1-102014 110 405
- JP-A- 2015 076 420
- US-A- 3 766 615
- US-A- 5 959 391
- US-A1- 2004 000 846

## Beschreibung

Die vorliegende Erfindung betrifft ein Verfahren zur Herstellung eines piezoelektrischen Transformators.

Der piezoelektrische Transformator kann insbesondere in einer Vorrichtung zur Erzeugung eines nichtthermischen Atmosphärendruck-Plasmas eingesetzt werden.

Die Verwendung von piezoelektrischen Transformatoren, insbesondere Transformatoren vom Rosen-Typ, zur Erzeugung von nichtthermischen Atmosphärendruck-Plasma ist bekannt. Bei der Herstellung ergeben sich nicht unerhebliche Schwierigkeiten dadurch, dass eine Polarisation eines piezoelektrischen Materials im Ausgangsbereich des piezoelektrischen Transformators üblicherweise dadurch vorgenommen wird, dass ein elektrisches Potential an eine auf der ausgangsseitigen Stirnseite aufgebrachte Metallisierung angelegt wird. Das Aufbringen einer Metallisierung auf die ausgangsseitige Stirnseite ist bei piezoelektrischen Transformatoren, die in einer longitudinalen Richtung eine deutlich größere Ausdehnung aufweisen als in zu dieser Richtung senkrechten Raumrichtungen, jedoch fertigungstechnisch schwierig. Oftmals sind für den Auftrag der Metallisierung zwei Maschinen erforderlich, um die Dimensionsunterschiede des piezoelektrischen Bauelementes berücksichtigen zu können. Außerdem muss das Bauteil festgehalten werden, um die Stirnseite separat von den übrigen Seitenflächen des Bauteils behandeln zu können. Auch dieses Festhalten ist aufgrund der Dimensionen des Transformators nicht einfach.

Ein weiterer Nachteil der auf der ausgangsseitigen Stirnseite aufgetragenen Metallisierung besteht darin, dass bei Verwendung des piezoelektrischen Transformators zur Plasmaerzeugung die ausgangsseitige Stirnseite erheblichen Beanspruchungen infolge von Temperaturänderungen und der auftretenden chemischen Vorgänge bei der Plasmaerzeugung ausgesetzt ist. Die auf der ausgangsseitigen Stirnseite aufgetragene Metallisierung kann durch diese Beanspruchungen beschädigt werden, wodurch eine Zerstörung des piezoelektrischen Transformators bewirkt werden kann.

WO 2007/006298 A2 zeigt eine Vorrichtung zur Plasmaerzeugung mit einem piezoelektrischen Transformator, bei dem der Ausgangsbereich mehrere Teilbereiche aufweist, die unmittelbar nebeneinander angeordnet sind und eine zueinander entgegengesetzte Polarisation aufweisen. DE 102014110405 A1 zeigt einen weiteren piezoelektrischen Transformator. US 3,766,615 A zeigt das Polarisieren eines piezoelektrischen Transformators, wobei ein Gummipad gegen eine ausgangsseitige Stirnseite gepresst wird und wobei zwei weitere Gummipads gegen einen Eingangsbereich gepresst werden. JP 2015-076420 A beschreibt eine Kapazitätsmessung zur Prüfung einer vorherigen Polarisation eines Bauelementes. Weitere bekannte Verfahrensschritte sind in US 2004 / 000846 A1, US 5 959 391 und EP 0 794 580 A1 beschrieben. Keines der zitierten Dokumente beschreibt die Verwendung eines entfernbaren Kontakts, der eine flexible Metallstruktur wie durch Anspruch 1 definiert.

Aufgabe der vorliegenden Erfindung ist es daher, ein verbessertes Herstellungsverfahren zur Herstellung eines piezoelektrischen Transformators anzugeben, das die oben genannten Nachteile überwindet. Eine weitere Aufgabe der vorliegenden Erfindung ist es, einen verbesserten piezoelektrischen Transformator anzugeben.

Die Aufgabe wird durch ein Verfahren gemäß dem vorliegenden Anspruch 1 gelöst.

Es wird ein Verfahren zur Herstellung eines piezoelektrischen Transformators vorgeschlagen. Das Verfahren weist die folgenden Schritte auf:
a) Fertigen eines Grundkörpers aufweisend einen Eingangsbereich, in dem Elektroden und ein erstes piezoelektrisches Material abwechselnd übereinandergestapelt sind, und einen Ausgangsbereich, der ein zweites piezoelektrisches Material aufweist,
b) Polarisieren des ersten piezoelektrischen Materials,
c) Anbringen eines entfernbaren Kontakts an eine ausgangsseitige Stirnseite des Grundkörpers, die vom Eingangsbereich weg weist und Anlegen eines ersten elektrischen Potentials an den entfernbaren Kontakt zur Polarisierung des zweiten piezoelektrischen Materials, wobei der entfernbare Kontakt eine flexible Metallstruktur (14) aufweist.
wobei die Schritte b) und c) in einer beliebigen Reihenfolge durchgeführt werden.

Durch die Verwendung eines entfernbaren Kontaktes in Schritt c) kann auf eine Metallisierung der ausgangsseitigen Stirnseite verzichtet werden. Die Verwendung des entfernbaren Kontaktes, der beispielsweise als flexibles Kontaktelement aufgepresst werden kann oder der als temporär aufgetragene Schicht aufgebracht werden kann, ist fertigungstechnisch mit wesentlich weniger Aufwand verbunden als das Aufbringen einer Metallisierung auf der ausgangsseitigen Stirnseite, die dauerhaft auf der Stirnseite verbleibt. Dementsprechend führt insbesondere Schritt c) zu einem einfachen Herstellungsverfahren.

Außerdem kann auf diese Weise ein piezoelektrischer Transformator gefertigt werden, dessen ausgangsseitige Stirnseite frei von einer Metallisierung ist. Dementsprechend ist die ausgangsseitige Stirnseite weniger anfällig gegen Beschädigungen durch Temperaturänderungen oder chemische Vorgänge während der Plasmaerzeugung im Betrieb des piezoelektrischen Transformators. Dadurch erlaubt das Verfahren die Fertigung eines piezoelektrischen Transformators, der eine besonders lange Lebensdauer aufweist, da er wenig empfindlich gegen Beschädigungen durch Temperaturänderungen oder chemische Vorgänge bei der Plasmaerzeugung ist.

Die ausgangsseitige Stirnseite kann rechteckig sein, wobei die ausgangsseitige Stirnseite beispielsweise Seitenlängen von 3mm und 6mm aufweist. Der piezoelektrische Transformator kann ferner in einer longitudinalen Richtung eine Länge von 70 mm aufweisen.

Der Eingangsbereich kann zwei Außenelektroden aufweisen, wobei die Elektroden im Eingangsbereich jeweils mit einer der Außenelektroden verbunden sind. Zur Polarisierung des zweiten piezoelektrischen Materials kann ein zweites elektrisches Potential an die beiden Außenelektroden angelegt werden, sodass zwischen den Elektroden des Eingangsbereichs und dem entfernbaren Kontakt eine Spannung anliegt. Durch diese Spannung kann das zweite piezoelektrische Material polarisiert werden. Es müssen dementsprechend zur Polarisierung des zweiten piezoelektrischen Materials keinerlei Elemente an dem piezoelektrischen Transformator angebracht werden, die dauerhaft an diesem verbleiben und keine Funktion im Betrieb des Transformators aufweisen.

Nach Beendigung des Schrittes C) kann der entfernbare Kontakt entfernt werden.

Der entfernbare Kontakt kann angebracht werden, in dem ein Kontaktelement gegen die Stirnseite gepresst wird. Durch das Pressen kann sichergestellt werden, dass das Kontaktelement sich gut an die Form der ausgangsseitigen Stirnseite anpasst und sich bündig an diese anschmiegt. Damit kann sichergestellt werden, dass ein elektrisches Potential gut von dem Kontaktelement auf die ausgangsseitige Stirnseite übertragen wird.

Der entfernbare Kontakt weist erfindungsgemäß eine flexible Metallstruktur auf. Die Metallstruktur kann beispielsweise ein Metallgitter sein. Beim Anpressen des Kontaktes an die ausgangsseitige Stirnseite kann sich dabei die Metallstruktur derart verformen, dass sie die Form der ausgangsseitigen Stirnseite annimmt. Metall eignet sich ferner deshalb gut, da es temperaturbeständig ist und Hitze, die beim Polarisieren des zweiten piezoelektrischen Materials auftritt, nicht zu einer Beschädigung der flexiblen Metallstruktur führt.

Das Verfahren kann ferner den Schritt d) aufweisen. In Schritt d) kann eine Impedanz und/oder eine Kapazität des piezoelektrischen Transformators gemessen werden, wobei an die ausgangsseitige Stirnseite in diesem Schritt mittels eines entfernbaren Kontakts ein drittes Potential angelegt wird. Ein viertes Potential kann dabei an die Elektroden des Eingangsbereichs über die Außenelektroden angelegt werden. Die Kapazität und/oder die Impedanz können für den Eingangsbereich und den Ausgangsbereich in separaten Teilschritten des Schritts d) ermittelt werden. Dieser Schritt ermöglicht eine Qualitätskontrolle, bei der sichergestellt werden kann, dass die vorher durchgeführte Polarisierung in ausreichendem Maße erfolgt ist.

Ein piezoelektrischer Transformator kann mit dem oben beschriebenen Herstellungsverfahren gefertigt werden. Der piezoelektrische Transformator weist einen Grundkörper mit einem Eingangsbereich, in dem Elektroden und ein erstes piezoelektrisches Material abwechselnd übereinandergestapelt sind, und einen Ausgangsbereich, der ein zweites piezoelektrisches Material aufweist, auf. Der Grundkörper weist eine ausgangsseitige Stirnseite auf, die vom Eingangsbereich weg weist und die frei von einer Metallisierung ist.

Der piezoelektrische Transformator kann insbesondere zur Erzeugung von nichtthermischem Atmosphärendruck-Plasma vorgesehen sein. Eine Metallisierung der ausgangsseitigen Stirnseite kann in einem Transformator, dessen Aufgabe darin besteht, eine Hochspannung zu erzeugen, die von einer nachfolgenden Schaltung abgegriffen wird, als Arbeitselektrode verwendet werden. Die Plasmaerzeugung kann dagegen auch durch eine dielektrische Barrierenentladung erzeugt werden, bei der an der ausgangsseitigen Stirnseite ein ausreichend hohes elektrisches Potential erzeugt wird. Dementsprechend ist zur Plasmaerzeugung keine Metallisierung der ausgangsseitigen Stirnseite erforderlich.

Wie oben beschrieben, ist die Metallisierung der ausgangsseitigen Stirnseite auch zur Polarisierung des zweiten piezoelektrischen Materials nicht erforderlich.

Wird auf eine Metallisierung der ausgangsseitigen Stirnseite verzichtet, ist die ausgangsseitige Stirnseite weniger empfindlich gegen Beschädigungen durch Temperaturschwankungen oder chemische Vorgänge bei der Plasmaerzeugung.

Die Oberfläche der ausgangsseitigen Stirnseite kann aus dem zweiten piezoelektrischen Material bestehen. Dieses keramische Material ist widerstandsfähig gegen thermische und chemische Angriffe.

Außerdem beschrieben wird eine Vorrichtung zur Erzeugung eines nichtthermischen Atmosphärendruck-Plasmas, die einen piezoelektrischen Transformator aufweist. Bei dem piezoelektrischen Transformator handelt es sich dabei um den oben beschriebenen Transformator.

Im Folgenden wird die vorliegende Erfindung anhand der Zeichnungen näher beschrieben.
- Figur 1: zeigt eine perspektivische Ansicht eines piezoelektrischen Transformators,
- Figur 2: zeigt ein Diagramm des Ablaufs eines Verfahrens zur Herstellung des piezoelektrischen Transformators,
- Figur 3: zeigt ein Kontaktelement gemäß einem ersten Ausführungsbeispiel, und
- Figur 4: zeigt ein Kontaktelement gemäß einem zweiten Ausführungsbeispiel.

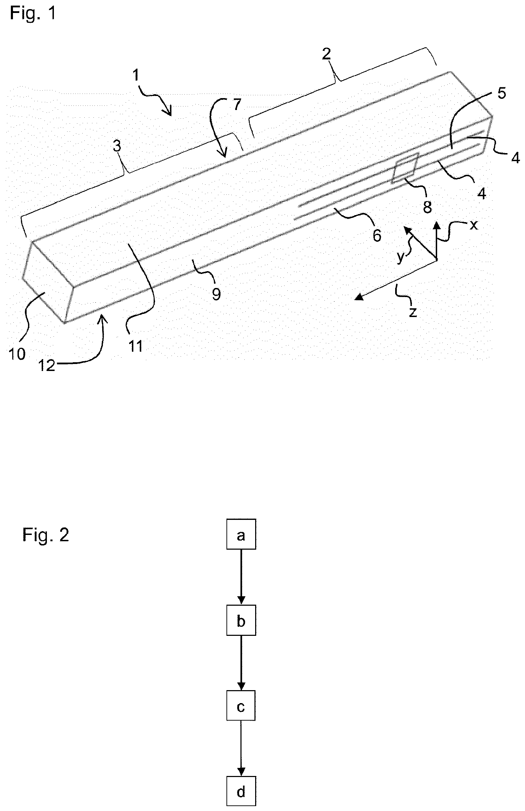

Figur 1 zeigt einen piezoelektrischen Transformator 1 in einer perspektivischen Ansicht. Der piezoelektrische Transformator 1 kann insbesondere in einer Vorrichtung zur Erzeugung von nichtthermischem Atmosphärendruck-Plasma eingesetzt werden.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf, wobei der Ausgangsbereich 3 sich in einer longitudinalen Richtung z an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der longitudinalen Richtung z des piezoelektrischen Transformators 1. Die Elektroden 4 sind in einer Stapelrichtung x, die senkrecht zu der longitudinalen Richtung z ist, abwechselnd mit einem ersten piezoelektrischen Material 5 gestapelt. Das erste piezoelektrische Material 5 ist dabei in Stapelrichtung x polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung x abwechselnd entweder mit der ersten Außenelektrode 8 oder der zweiten Außenelektrode elektrisch kontaktiert.

Ferner weist der piezoelektrische Transformator 1 eine dritte Seitenfläche 11 und eine vierte Seitenfläche 12 auf, die einander gegenüberliegen und die senkrecht zu der ersten Seitenfläche 6 und der zweiten Seitenfläche 7 angeordnet sind. Die Flächennormalen der dritten und der vierten Seitenflächen 11, 12 zeigen jeweils in Stapelrichtung x.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist ein zweites piezoelektrisches Material 9 auf und ist frei von innenliegenden Elektroden. Das zweite piezoelektrische Material 9 im Ausgangsbereich ist in der longitudinalen Richtung z polarisiert. Bei dem zweiten piezoelektrischen Material 9 des Ausgangsbereichs 3 kann es sich um das gleiche Material wie bei dem ersten piezoelektrischen Material 5 des Eingangsbereichs 2 handeln, wobei sich die beiden piezoelektrischen Materialien 5 und 9 in ihrer Polarisationsrichtung unterscheiden können. In einer bevorzugten Ausführungsform ist das zweite piezoelektrische Material 9 im Ausgangsbereich 3 zu einer einzigen monolithischen Schicht geformt, die vollständig in der longitudinalen Richtung z polarisiert ist. Dabei weist das piezoelektrische Material 9 im Ausgangsbereich 3 nur eine einzige Polarisationsrichtung auf.

Alternativ kann das zweite piezoelektrische Material 9 im Ausgangsbereich 3 einige, wenige Schichten bilden, die jeweils in zueinander entgegengesetzte Richtungen polarisiert sind, wobei die Schichten entweder in der positiven longitudinalen Richtung z oder in der negativen longitudinalen Richtung -z polarisiert sind.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Die Spannungstransformation wird dabei durch die Dicke der Schichten aus piezoelektrischem Material 5, 9 im Eingangsbereich 2 und im Ausgangsbereich 3 bestimmt.

Der Ausgangsbereich 3 weist eine ausgangsseitige Stirnseite 10 auf. Die im Ausgangsbereich 3 erzeugte elektrische Spannung liegt somit zwischen der Stirnseite 10 und dem Ende der Elektroden 4 des Eingangsbereichs 2 an. An der ausgangsseitigen Stirnseite 10 entsteht dabei ein sehr hohes Potential. Dadurch entsteht auch zwischen der ausgangseitigen Stirnseite 10 und einer Umgebung des piezoelektrischen Transformators eine hohe Potentialdifferenz, die ausreicht, um ein starkes elektrisches Feld zu erzeugen, dass ein Prozessgas ionisiert.

Auf diese Weise erzeugt der piezoelektrische Transformator 1 hohe elektrische Felder, die in der Lage sind, Gase oder Flüssigkeiten durch elektrische Anregung zu ionisieren. Es kommt dabei zu einer dielektrischen Barrierenentladung. Dabei werden Atome oder Moleküle des jeweiligen Gases bzw. der jeweiligen Flüssigkeit ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle erforderlich ist.

Bei dem in Figur 1 eingezeichneten Koordinatensystem ist ferner eine y-Richtung y eingezeichnet, die senkrecht zur Stapelrichtung x und senkrecht zur longitudinalen Richtung z ist.

Im Folgenden wird ein Verfahren zur Herstellung des in Figur 1 gezeigten piezoelektrischen Transformators beschrieben. Dabei werden insbesondere die Polarisierung des ersten piezoelektrischen Materials im Eingangsbereich und die Polarisierung des zweiten piezoelektrischen Materials im Ausgangsbereich im Detail beschrieben.

Figur 2 zeigt ein Diagramm, das den Ablauf des Herstellungsverfahrens erläutert.

In einem ersten Fertigungsschritt a) wird ein Grundkörper des piezoelektrischen Transformators 1 gefertigt, der den Eingangsbereich 2 und den Ausgangsbereich 3 aufweist. Der Eingangsbereich 2 weist dabei, wie in Figur 1 bereits gezeigt, die Elektroden 4 und ein erstes piezoelektrisches Material 5 auf, wobei in der Stapelrichtung x die Elektroden 4 und das erste piezoelektrische Material 5 jeweils abwechselnd übereinandergestapelt sind. Der Ausgangsbereich 3 weist das zweite piezoelektrische Material 9 auf. Nach Beendigung des Schrittes a) sind sowohl das erste piezoelektrische Material 5 im Eingangsbereich 2 als auch das zweite piezoelektrische Material 9 im Ausgangsbereich 3 unpolarisiert.

In weiteren Schritten b), c) des Herstellungsverfahrens werden die piezoelektrischen Materialien 5, 9 im Eingangsbereich 2 und im Ausgangsbereich 3 polarisiert. Die Polarisation des Eingangsbereichs 2 und die Polarisation des Ausgangsbereiches 3 erfolgen in zwei getrennten Schritten b), c), wobei die Reihenfolge dieser beiden Schritte b), c) beliebig ist.

Es wird zunächst die Polarisierung des Eingangsbereichs 2 in einem Verfahrensschritt b) beschrieben. Ein elektrisches Potential wird an die erste Außenelektrode 8 angelegt und liegt somit auch an den mit der ersten Außenelektrode 8 verbundenen Elektroden 4 an. Ein davon verschiedenes elektrisches Potential wird ferner an die zweite Außenelektrode angelegt und liegt somit auch an den mit der zweiten Außenelektrode verbundenen Elektroden 4 an. Dementsprechend liegt nunmehr eine elektrische Spannung zwischen den im Eingangsbereich 2 abwechselnd übereinandergestapelten Elektroden 4 an. Durch diese Spannung wird das erste piezoelektrische Material 5 im Eingangsbereich 2 polarisiert.

Nunmehr wird ein Verfahrensschritt c) beschrieben, in dem das zweite piezoelektrische Material 9 im Ausgangsbereich 3 polarisiert wird. Zur Polarisation des zweiten piezoelektrischen Materials 9 wird eine Spannung angelegt zwischen der ausgangsseitigen Stirnseite 10 des Grundkörpers und den Enden der Elektroden 4 des Eingangsbereichs 2, die zum Ausgangsbereich 3 hinweisen. Ein erstes elektrisches Potential wird dabei an die ausgangsseitige Stirnseite 10 des Grundkörpers angelegt. Dieses erste elektrische Potential wird mittels eines entfernbaren Kontaktes an die ausgangsseitige Stirnseite 10 des Grundkörpers angelegt. Bei dem entfernbaren elektrischen Kontakt kann es sich beispielsweise um ein Kontaktelement 13 handeln, das von einer Vorrichtung gegen die ausgangsseitige Stirnseite 10 des Transformators 1 gepresst wird. Das Kontaktelement 13 ist dabei vorzugsweise flexibel und flächig ausgestaltet. Dadurch wird es ermöglicht, dass das Kontaktelement 13 sich an die Form der ausgangsseitigen Stirnseite 10 anpasst und an dieser bündig anliegt.

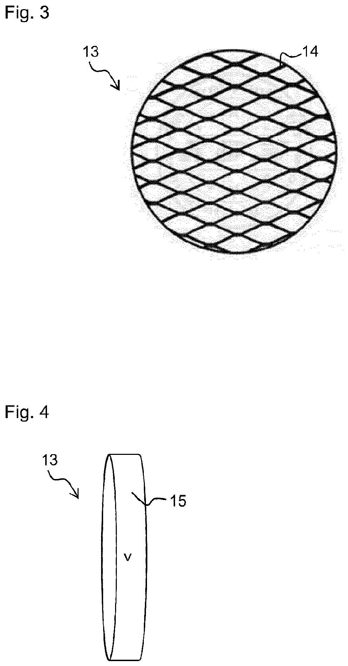

Die Figuren 3 und 4 zeigen verschiedene Ausführungsbeispiele für das Kontaktelement 13. Beispielsweise kann es sich bei dem Kontaktelement 13 um ein flexibles Metallgitter 14 handeln, wie in Figur 3 gezeigt. Bei dem Kontaktelement 13 kann es sich auch um eine Schicht 15 handeln, die ein leitfähiges Polymer aufweist. Die Schicht 15 kann beispielsweise scheibenförmig sein.

Die Schicht 15 kann zusätzlich zu dem leitfähigen Polymer oder alternativ zu dem leitfähigen Polymer ein mit leitfähigen Partikeln gefülltes Gummi beziehungsweise ein mit leitfähigen Partikeln gefülltes Silikon aufweisen. Erfindungsgemäß weist der entfernbare Kontakt eine flexible Metallstruktur auf. Beispiele, in denen der entfernbare Kontakt keine flexible Metallstruktur aufweist, liegen außerhalb der Erfindung.

Die in den Figuren 3 und 4 gezeigten Kontaktelemente 13 sind handelsüblich und werden beispielsweise für EMV-Abschirmungen (EMV = elektromagnetische Verträglichkeit) kommerziell angeboten.

Der entfernbare Kontakt sollte ferner temperaturbeständig sein, um durch Hitze, die bei der Polarisierung des zweiten piezoelektrischen Materials 9 auftritt, nicht beschädigt zu werden.

Ein zweites elektrisches Potential wird an die Elektroden 4 des Eingangsbereichs 2 angelegt. Dazu können die erste und die zweite Außenelektrode 8 kurzgeschlossen werden. Insbesondere kann das zweite elektrische Potential sowohl an die erste Außenelektrode 8 als auch an die zweite Außenelektrode angelegt werden. Dementsprechend liegt nunmehr an allen Elektroden 4 des Eingangsbereichs 2 das gleiche Potential an. Es bildet sich nunmehr eine elektrische Spannung zwischen der ausgangsseitigen Stirnseite 10, an die das erste elektrische Potential durch den entfernbaren Kontakt angelegt ist, und den Elektroden 4 des Eingangsbereiches 2 aus. Durch diese Spannung wird das zweite piezoelektrische Material 9 polarisiert.

Am Ende des Polarisierungsschrittes c) wird der entfernbare Kontakt von der ausgangsseitigen Stirnseite 10 wieder entfernt. Handelt es sich bei dem Kontakt um ein flexibles Kontaktelement 13, das von der Vorrichtung an die Stirnseite 10 angepresst wird, wird nunmehr einfach der Anpressdruck gelockert, sodass das Kontaktelement 13 von der Stirnseite 10 gelöst werden kann.

Ein alternatives Ausführungsbeispiel sieht vor, dass der entfernbare Kontakt auf der ausgangsseitigen Stirnseite 10 durch eine temporär aufgetragene Schicht gebildet wird. Dazu kann eine temporär vorhandene Kappe aufgebracht werden, in dem der piezoelektrische Transformator 1 mit seinem Ausgangsbereich 3 in ein Flüssigkeitsbad eingetaucht wird, das eine leitfähige Schicht auf der ausgangsseitigen Stirnseite 10 erzeugt. Die leitfähige Schicht kann beispielsweise ein leitfähiges Polymer und/oder mit leitfähigen Partikeln gefülltes Gummi aufweisen. An diese leitfähige Schicht kann in Schritt c) ein erstes elektrisches Potential angelegt werden. Ist das zweite piezoelektrische Material 9 polarisiert, so kann die leitfähige Kappe von dem piezoelektrischen Transformator 1 entfernt werden. Dazu kann die Kappe beispielsweise durch einen Schaber abgezogen werden. Diese Beispiele weisen keine flexible Metallstruktur auf und liegen daher außerhalb der Erfindung.

Nach Beendigung der Schritte b) und c) kann ein weiterer Schritt d) durchgeführt werden, der eine Qualitätskontrolle des gefertigten piezoelektrischen Transformators 1 ermöglicht. In Schritt d) können eine Kapazität und/oder eine Impedanz des Ausgangsbereichs 3 sowie eine Kapazität und/oder eine Impedanz des Eingangsbereichs 2 gemessen werden.

Zur Messung der Kapazität und/oder der Induktivität des Ausgangsbereichs 3 wird wiederum an die ausgangsseitige Stirnseite 10 mittels eines entfernbaren Kontaktes ein drittes elektrisches Potential angelegt. An die beiden Außenelektroden 8 des Eingangsbereichs 2 wird jeweils ein viertes elektrisches Potential angelegt, sodass alle Elektroden 4 des Eingangsbereichs 2 auf dem gleichen elektrischen Potential liegen. Es bildet sich wieder eine elektrische Spannung zwischen der ausgangsseitigen Stirnseite 10 und den Elektroden 4 des Eingangsbereichs 2. Nunmehr können die Kapazität und/oder die Impedanz des Eingangsbereichs 2 vermessen werden. Die Messung dieser Größen ermöglicht es insbesondere, zu prüfen, ob eine Polarisierung des zweiten piezoelektrischen Materials 5 in ausreichendem Maße erfolgt ist.

In Schritt d) kann ferner auch die Polarisierung des ersten piezoelektrischen Materials 9 im Eingangsbereich 2 geprüft werden, indem an die erste Außenelektrode 8 und an die zweite Außenelektrode jeweils ein elektrisches Potential angelegt wird.

Bei dem in Schritt d) verwendeten entfernbaren Kontakt kann es sich um den bereits in Schritt c) verwendeten entfernbaren Kontakt handeln.

Wie hier beschrieben, wird ein elektrisches Potential an die ausgangsseitige Stirnseite 10 während des Herstellungsverfahrens angelegt, ohne dass dafür eine Metallisierung auf die ausgangsseitige Stirnseite 10 aufgebracht werden müsste. Stattdessen wird der entfernbare Kontakt verwendet, der vor Abschluss des Verfahrens von dem Transformator 1 wieder entfernt wird. Dementsprechend kann die ausgangsseitige Stirnseite 10 frei von einer Metallisierung sein und vielmehr aus dem zweiten piezoelektrischen Material 9 bestehen.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: erste Außenelektrode
- 9: piezoelektrisches Material
- 10: ausgangsseitige Stirnseite
- 11: dritte Seitenfläche
- 12: vierte Seitenfläche
- 13: Kontaktelement
- 14: Metallgitter
- 15: Schicht

- x: Stapelrichtung
- y: y-Richtung
- z: longitudinale Richtung

## Patentansprüche

1. Verfahren zur Herstellung eines piezoelektrischen Transformators (1), aufweisend die Schritte:
a) Fertigen eines Grundkörpers aufweisend einen Eingangsbereich (2), in dem Elektroden (4) und ein erstes piezoelektrisches Material (5) abwechselnd übereinander gestapelt sind, und einen Ausgangsbereich (3), der ein zweites piezoelektrisches Material (9) aufweist,
b) Polarisieren des ersten piezoelektrischen Materials (5) ,
c) Anbringen eines entfernbaren Kontakts an eine ausgangsseitige Stirnseite (10) des Grundkörpers, die vom Eingangsbereich (2) weg weist und Anlegen eines ersten elektrischen Potentials an den entfernbaren Kontakt zur Polarisierung des zweiten piezoelektrischen Materials (9), wobei der entfernbare Kontakt eine flexible Metallstruktur (14) aufweist,
wobei die Schritte b) und c) in einer beliebigen Reihenfolge durchgeführt werden.

2. Verfahren gemäß Anspruch 1,
wobei der Eingangsbereich (2) zwei Außenelektroden (8) aufweist und die Elektroden (4) im Eingangsbereich (2) jeweils mit einer der zwei Außenelektroden (8) verbunden sind, und
wobei zur Polarisierung des zweiten piezoelektrischen Materials (9) ein zweites elektrisches Potential an die beiden Außenelektroden (8) angelegt wird, so dass zwischen den Elektroden (4) des Eingangsbereichs (2) und der ausgangsseitigen Stirnseite (10) eine Spannung anliegt.

3. Verfahren gemäß einem der vorherigen Ansprüche, wobei nach Beendigung des Schritts c) der entfernbare Kontakt entfernt wird.

4. Verfahren gemäß einem der vorherigen Ansprüche, wobei der entfernbare Kontakt angebracht wird, indem ein Kontaktelement (13) gegen die Stirnseite (10) gepresst wird.

5. Verfahren gemäß einem der vorherigen Ansprüche, ferner aufweisend den Schritt:
d) Messung einer Impedanz und/oder einer Kapazität des piezoelektrischen Transformators (1), wobei an die ausgangsseitige Stirnseite (10) in diesem Schritt mittels eines entfernbaren Kontakts ein drittes Potential angelegt wird.

6. Verfahren gemäß einem der vorherigen Ansprüche, wobei es sich bei dem piezoelektrischen Transformator um einen Transformator zur Erzeugung von nichtthermischen Atmosphärendruck-Plasma handelt.

## Claims

1. Method for producing a piezoelectric transformer (1), comprising the steps of:
a) manufacturing a main body having an input region (2), in which electrodes (4) and a first piezoelectric material (5) are alternately stacked one on top of the other, and an output region (3) which has a second piezoelectric material (9),
b) polarizing the first piezoelectric material (5),
c) fitting a removable contact to an output-side end side (10) of the main body, which end side faces away from the input region (2), and applying a first electrical potential to the removable contact for polarizing the second piezoelectric material (9), wherein the removable contact has a flexible metal structure (14),
wherein steps b) and c) are carried out in any desired order.

2. Method according to Claim 1,
wherein the input region (2) has two outer electrodes (8), and the electrodes (4), in the input region (2), are respectively connected to one of the two outer electrodes (8), and
wherein, for polarizing the second piezoelectric material (9), a second electrical potential is applied to the two outer electrodes (8), so that a voltage is applied between the electrodes (4) of the input region (2) and the output-side end side (10).

3. Method according to either of the preceding claims, wherein, after completion of step c), the removable contact is removed.

4. Method according to one of the preceding claims, wherein the removable contact is fitted by a contact element (13) being pressed against the end side (10).

5. Method according to one of the preceding claims, further comprising the step of:
d) measuring an impedance and/or a capacitance of the piezoelectric transformer (1), wherein a third potential is applied to the output-side end side (10) by means of a removable contact in this step.

6. Method according to one of the preceding claims, wherein the piezoelectric transformer is a transformer for generating non-thermal atmospheric pressure plasma.

## Revendications

1. Procédé de fabrication d'un transformateur piézoélectrique (1), présentant les étapes consistant à :
a) produire un corps de base présentant une zone d'entrée (2) dans laquelle des électrodes (4) et un premier matériau piézoélectrique (5) sont empilés en alternance les uns sur les autres, et une zone de sortie (3) qui présente un deuxième matériau piézoélectrique (9),
b) polariser le premier matériau piézoélectrique (5),
c) fixer un contact amovible sur une face frontale côté sortie (10) du corps de base, qui est détournée de la zone d'entrée (2), et appliquer un premier potentiel électrique au contact amovible pour la polarisation du deuxième matériau piézoélectrique (9), le contact amovible présentant une structure métallique souple (14),
les étapes b) et c) étant effectuées dans un ordre quelconque.

2. Procédé selon la revendication 1, dans lequel la zone d'entrée (2) présente deux électrodes extérieures (8), et les électrodes (4) dans la zone d'entrée (2) sont reliées respectivement à l'une des deux électrodes extérieures (8), et
dans lequel, pour la polarisation du deuxième matériau piézoélectrique (9), un deuxième potentiel électrique est appliqué aux deux électrodes extérieures (8) de sorte qu'une tension est appliquée entre les électrodes (4) de la zone d'entrée (2) et la zone frontale côté extérieur (10).

3. Procédé selon l'une quelconque des revendications précédentes, dans lequel le contact amovible est retiré à l'issue de l'étape c).

4. Procédé selon l'une quelconque des revendications précédentes, dans lequel le contact amovible est fixé en pressant un élément de contact (13) contre la face frontale (10).

5. Procédé selon l'une quelconque des revendications précédentes, présentant en outre l'étape consistant à : d) mesurer une impédance et/ou une capacité du transformateur piézoélectrique (1), dans cette étape un troisième potentiel étant appliqué à la face frontale côté sortie (10) au moyen d'un contact amovible.

6. Procédé selon l'une quelconque des revendications précédentes, dans lequel le transformateur piézoélectrique est un transformateur destiné à produire un plasma à pression atmosphérique non thermique.
